# EUROPÄISCHE PATENTSCHRIFT

(11) **EP 3 715 864 B1**
(45) Veröffentlichungstag und Bekanntmachung des Hinweises auf die Patenterteilung: **21.06.2023**
(21) Anmeldenummer: 20166302.8
(22) Anmeldetag: 27.03.2020
(51) Int. Cl.: G01R 1/04, G01R 31/28

(54) **TESTVORRICHTUNG UND VERWENDUNG DER TESTVORRICHTUNG**
TEST DEVICE AND USE OF THE TEST DEVICE
DISPOSITIF D'ESSAI ET UTILISATION DU DISPOSITIF D'ESSAI

(30) Priorität: 29.03.2019 DE 102019002342
(43) Veröffentlichungstag der Anmeldung: 30.09.2020
(73) Patentinhaber: Yamaichi Electronics Deutschland GmbH, 85609 Aschheim-Dornach (DE)
(72) Erfinder: Btahri, Jemei, 4000 Sousse (TN); Quiter, Michael, 57482 Wenden (DE)
(74) Vertreter: Müller-Boré & Partner Patentanwälte PartG mbB

(56) Entgegenhaltungen:
- EP-A1- 0 372 666
- WO-A1-2015/132748
- FR-A1- 2 608 775

## Beschreibung

Die Erfindung betrifft eine Testvorrichtung und die Verwendung einer Testvorrichtung, insbesondere für das Testen elektronischer Module auf einer Leiterplatine.

Üblicherweise werden Leiterplatinen wie beispielsweise PCBs (printed circuit boards) und die auf ihnen vorhandenen elektronischen Module wie beispielsweise integrierte Schaltkreise nach der Fertigung auf ihre Funktionstüchtigkeit geprüft. Zu diesem Zweck werden manuell betriebene oder automatisierte Testvorrichtungen benutzt. Solche Testvorrichtungen bestehen normalerweise aus einem Vorrichtungsdeckel, der über Testkontakte verfügt, die im Testfall auf die zu prüfende Leiterplatine mittels des Vorrichtungsdeckels abgesenkt und mit dieser in Kontakt gebracht werden, und einer Leiterplatinenaufnahme, die ihrerseits über Testkontakte verfügen kann. Zum Überprüfen elektronischer Module der Leiterplatine wird die Leiterplatine in die Leiterplatinenaufnahme gelegt und mittels des abgesenkten Vorrichtungsdeckels in die Leiterplatinenaufnahme gedrückt, so dass bei einer beidseitigen Bestückung der Leiterplatine beide Seiten in Kontakt mit Testkontakten der Testvorrichtung treten können und somit überprüft werden können.

Die FR 2 608 775 A1 offenbart eine Testvorrichtung für Leiterplatten, wobei die Testvorrichtung an zwei gegenüberliegenden Seiten jeweils mehrere Platten aufweist, welche über eine Führungsstift-Loch-Verbindung miteinander verbindbar sind.

Aus der WO 2015/132748 A1 ist eine Testvorrichtung für Leiterplatten bekannt, bei welcher mittels Einstellschrauben die Neigung eines Testkopfes einstellbar ist.

Die EP 0 372 666 A1 beschreibt eine Testvorrichtung für eine Leiterplatte, bei welcher die Leiterplatte in einem mittig angeordneten Rahmen der Testvorrichtung angeordnet werden kann und ein oberer Rahmen der Testvorrichtung eine Kontaktstoffträgerplatte aufweist, an deren Unterseite über Federn eine Niederhalteplatte mit zapfenförmigen Andrückelementen befestigt ist.

Für ein verlässliches und genaues Testen der Funktionstüchtigkeit elektronischer Module wie Schaltkreise auf Leiterplatinen müssen die Testkontakte der dafür vorgesehenen Testvorrichtungen mit hoher Genauigkeit relativ zu den zu testenden Schaltkreisen angeordnet werden können. Aus dem Stand der Technik bekannte Testvorrichtungen haben allerdings den Nachteil, dass sie feinmechanisch extrem genau steuerbar sein müssen, wodurch die Fertigung und der Betrieb solcher Testvorrichtung aufwändig und kostenintensiv sind. Zudem können etwaige Abweichungen der Testkontakte relativ zu den zu testenden elektronischen Modulen einer Leiterplatine bedingt durch systematische Fehlertoleranzen bei der Fertigung, z. B. der elektronischen Leiterplatinen, bzw. dem Betrieb besagter Testvorrichtungen nicht auf einfache Weise ausgeglichen werden.

Eine Aufgabe der vorliegenden Erfindung ist es daher, eine in ihrer Fertigung und ihrem Betrieb einfache und kostengünstige Testvorrichtung bereitzustellen, die es ermöglicht, Abweichungen der Testkontakte relativ zu den zu testenden bzw. zu kontaktierenden elektronischen Modulen einer Leiterplatine auszugleichen.

Die obige Aufgabe wird durch die unabhängigen Ansprüche gelöst. Bevorzugte Ausführungsformen ergeben sich aus den abhängigen Ansprüchen.

Ein Aspekt der vorliegenden Erfindung ist eine Testvorrichtung, insbesondere für das Testen elektronischer Module auf einer Leiterplatine, umfassend:
- zumindest einen oberen Testkontaktor zum elektrischen Kontaktieren eines Bereichs einer Oberseite einer Leiterplatine, wobei der zumindest eine obere Testkontaktor zumindest eine Führungsausnehmung aufweist,
- zumindest einen unteren Testkontaktor zum elektrischen Kontaktieren eines Bereichs einer Unterseite der Leiterplatine, wobei der zumindest eine untere Testkontaktor zumindest einen Führungsstift zum Ausrichten der Leiterplatine relativ zu dem zumindest einen unteren Testkontaktor aufweist, wobei der zumindest eine Führungsstift von dem zumindest einen unteren Testkontaktor hervorragt, wobei in einem Betriebszustand der Testvorrichtung der zumindest eine Führungsstift in die zumindest eine Führungsausnehmung eingreift, wodurch der zumindest eine obere Testkontaktor relativ zu der Leiterplatine und dem zumindest einen unteren Testkontaktor ausgerichtet ist,
- ein oberes Andrückelement zum Andrücken des zumindest einen oberen Testkontaktors an den zu kontaktierenden Bereich der Oberseite der Leiterplatine, und
- eine Vielzahl von oberen Ausrichtelementen zum Ausrichten des zumindest einen oberen Testkontaktors in einem Offenzustand der Testvorrichtung relativ zu dem oberen Andrückelement,
wobei die Testvorrichtung eine Vielzahl der genannten oberen und unteren Testkontaktoren aufweist.

Im Rahmen der vorliegenden Anmeldung bezieht sich der Begriff "Leiterplatine" auf aus einem isolierenden Trägermaterial, wie z. B. Kunstharz, geformte Platten bzw. Plättchen oder Karten, auf welchen in Bereichen der Oberseite und/oder in Bereichen der Unterseite elektronische Module angeordnet sind. Die elektronischen Module können hierbei an der Leiterplatine verlötet, auf die Leiterplatine geklebt, geschraubt oder beim Gießen der Leiterplatine in die Leiterplatine eingearbeitet sein. Der Begriff "Leiterplatine" umfasst ferner sogenannte printed circuit boards (PCB) bzw. PCB-Karten.

Der Begriff "elektronisches Modul" umfasst im Rahmen der vorliegenden Anmeldung elektrische Schaltungen aller Art wie beispielsweise analoge Schaltkreise, digitale Schaltkreise, integrierte Schaltkreise oder eine Kombination der genannten Schaltkreise, umfassend Leiterbahnen und elektronische Bauteile.

Vorteilhafterweise ermöglicht es die erfindungsgemäße Testvorrichtung, den zumindest einen oberen Testkontaktor mittels des zumindest einen Führungsstifts mit hoher Genauigkeit über der Leiterplatine und relativ zu dem beidseitig zu testenden elektronischen Modul der Leiterplatine auszurichten.

Weiterhin ermöglicht es die erfindungsgemäße Testvorrichtung vorteilhafterweise, aus dem Betriebszustand der Testvorrichtung resultierende Verrückungen oder Verschiebungen des zumindest einen oberen Testkontaktors relativ zu dem oberen Andrückelement, insbesondere in einer Ebene parallel zu dem oberen Andrückelement, in einem Offenzustand der Testvorrichtung, d. h. in einem Zustand, in dem der zumindest eine obere Testkontaktor die Oberseite der Leiterplatine nicht kontaktiert oder berührt bzw. die Testvorrichtung offensteht und das obere Ende des zumindest einen Führungsstifts sichtbar ist, mittels der oberen Ausrichtelemente auszugleichen und den zumindest einen oberen Testkontaktor in seine vorbestimmte Ausgangslage relativ zu dem oberen Andrückelement auszurichten.

Die Begriffe "Offenzustand" bzw. "offener Zustand" im Sinne der vorliegenden Anmeldung beziehen sich im Wesentlichen auf räumliche Positionen des zumindest einen oberen Testkontaktors. Im Offenzustand bzw. im offenen Zustand kann eine Leiterplatine in der Testvorrichtung vorhanden sein oder eingebracht werden. Der zumindest eine obere Testkontaktor ist im Offenzustand bzw. im offenen Zustand der Testvorrichtung so angeordnet, dass die zumindest eine Führungsausnehmung des zumindest einen oberen Testkontaktors im Wesentlichen in einer Richtung, in der der zumindest eine Führungsstift vorspringt, von dem vorspringenden Ende des zumindest einen Führungsstifts einen von Null verschiedenen Abstand hat. Im Offenzustand bzw. im offenen Zustand der Testvorrichtung kann der zumindest eine obere Testkontaktor ferner so angeordnet sein, dass die Längsachsen in der Richtung, in welcher der zumindest eine Führungsstift vorspringt, des zumindest einen Führungsstifts und der zumindest einen Führungsausnehmung um einen Winkel gegeneinander verkippt sind.

Außerdem ermöglicht es die erfindungsgemäße Testvorrichtung vorteilhafterweise, auf einfache kostengünstige und verlässliche Weise etwaige fertigungs- und/oder steuerungsbedingte Fehlertoleranzen bzw. Auslenkungen oder örtliche Versätze in der Anordnung des zumindest einen oberen Testkontaktors relativ zu einem zu testenden elektronischen Modul einer in die Testvorrichtung eingebrachten Leiterplatine und relativ zu dem zumindest einen unteren Testkontaktor, der besagtes Modul auf der Unterseite der Leiterplatine kontaktiert, in einem Betriebszustand der Testvorrichtung auszugleichen, so dass der zumindest eine obere Testkontaktor relativ zu dem beidseitig zu testenden elektronischen Modul exakt angeordnet werden kann und der zumindest eine obere Testkontaktor besagtes elektronisches Modul exakt elektrisch kontaktieren kann.

Der Begriff "Betriebszustand" im Sinne der vorliegenden Anmeldung bezieht sich auf den Zustand der Testvorrichtung, in dem eine Leiterplatine in der Testvorrichtung vorhanden ist. Hierfür wird in der Leiterplatine zumindest eine Durchgangsöffnung, die zum Beispiel eine Durchgangsbohrung sein kann, vorgesehen, mittels der die Leiterplatine anhand des zumindest einen Führungsstifts über dem zumindest einen unteren Testkontaktor ausgerichtet werden kann. Ferner ist der Betriebszustand derjenige Zustand der Testvorrichtung, in dem das obere Andrückelement den zumindest einen oberen Testkontaktor an die Oberseite der zu prüfenden Leiterplatine andrückt, so dass der zumindest eine obere Testkontaktor ein zu testendes elektronisches Modul elektrisch kontaktiert. Dazu greift der zumindest eine Führungsstift in die zumindest eine Führungsausnehmung des zumindest einen oberen Testkontaktors ein bzw. der zumindest eine Führungsstift wird in die zumindest eine Führungsausnehmung eingeführt. Mit anderen Worten ist im Betriebszustand der Testvorrichtung der vertikale Abstand zwischen dem hervorragenden Ende des zumindest einen Führungsstifts und der zumindest einen Führungsausnehmung kleiner Null, so dass das besagte Ende des zumindest einen Führungsstifts in der zumindest einen Führungsausnehmung aufgenommen wird und/oder die zumindest eine Führungsausnehmung durchdringt und der zumindest eine obere Testkontaktor die Leiterplatine kontaktiert.

Im Rahmen dieser Anmeldung beziehen sich alle Richtungsangaben wie "oben", "unten", "longitudinal" bzw. "längs", "transversal" bzw. "quer", "horizontal" und "vertikal", wenn nichts anderes explizit bestimmt ist, auf ein mit dem zumindest einen unteren Testkontaktor verhaftetes dreidimensionales kartesisches Bezugskoordinatensystem. Das Bezugskoordinatensystem ist so orientiert, dass der zumindest eine Führungsstift entlang der y-Achse des Bezugskoordinatensystems von dem zumindest einen unteren Testkontaktor hervorragt. D. h. der zumindest eine Führungsstift ragt in positiver y-Richtung hervor. Der zumindest eine untere Testkontaktor ist derart ausgebildet, dass er sich im Wesentlichen in der zx-Ebene des Bezugskoordinatensystems erstreckt. Somit beziehen sich die Angaben "oben", "unten" und "vertikal" auf die y-Achse des Bezugskoordinatensystems, wohingegen sich die Angabe "longitudinal" bzw. "längs" auf die x-Achse, die Angabe "transversal" bzw. "quer" auf die z-Achse und die Angabe "horizontal" auf die durch die z- und x-Achse aufgespannte zx-Ebene bezieht.

Die Testvorrichtung wird insbesondere zum Testen von bereits erwähnten elektronischen Modulen einer Leiterplatine verwendet.

Der zumindest eine obere Testkontaktor ist im Betriebszustand der Testvorrichtung im Wesentlichen auf einem zu testenden elektronischen Modul auf der Oberseite der Leiterplatine angeordnet, um besagtes elektronisches Modul beispielsweise mittels einer Vielzahl von Kontaktpins elektrisch zu kontaktieren. Die Oberseite ist hierbei die Seite der Leiterplatine, bei der eine Flächennormale in positiver y-Richtung des Bezugskoordinatensystems weist. Der zumindest eine obere Testkontaktor kann wie erwähnt eine Vielzahl von Kontaktpins an einer Seite des zumindest einen oberen Testkontaktors, die im Betriebszustand der Testvorrichtung der Oberseite der Leiterplatine gegenüberliegt, aufweisen. Diese Kontaktpins weisen demnach im Betriebszustand der Testvorrichtung zur Oberseite der Leiterplatine hin, folglich in negative y-Richtung des Bezugskoordinatensystems. Mittels der Kontaktpins kann ein elektronisches Modul auf der Oberseite der Leiterplatine elektrisch kontaktiert werden. Ferner kann der zumindest eine obere Testkontaktor zumindest eine Führungsausnehmung in einem nichtleitenden Bereich der Unterseite des zumindest einen oberen Testkontaktors, die im Betriebszustand der Testvorrichtung der Oberseite der Leiterplatine gegenüberliegt, aufweisen. Und zwar kann die zumindest eine Führungsausnehmung in einem Außenbereich der Unterseite des zumindest einen oberen Testkontaktors angeordnet sein, wo sich keine Kontaktpins befinden. Die zumindest eine Führungsausnehmung kann derart geformt sein, dass sie sich im Betriebszustand der Testvorrichtung in y-Richtung erstreckt. Die zumindest eine Führungsausnehmung kann eine Bohrung im zumindest einen oberen Testkontaktor sein. Die zumindest eine Führungsausnehmung kann aber auch eine bei der Fertigung des zumindest einen oberen Testkontaktors geformte Aussparung oder Öffnung sein. Im Betriebszustand der Testvorrichtung kann der Querschnitt der zumindest einen Führungsausnehmung senkrecht zur y-Richtung rund oder vieleckig sein.

Vorteilhafterweise können beim Überführen der Testvorrichtung vom Offenzustand in den Betriebszustand mittels der zumindest einen Führungsausnehmung herstellungsbedingte bzw. verfahrensbedingte (beispielsweise aufgrund der Steuerung durch einen Roboterarm) Fehlertoleranzen bei der räumlichen Ausrichtung des zumindest einen oberen Testkontaktors relativ zu dem zu kontaktierenden elektronischen Modul der Leiterplatine ausgeglichen werden. Beim Zurückführen der Testvorrichtung vom Betriebszustand in den Offenzustand ermöglicht die Vielzahl von oberen Ausrichtelementen, dass der zumindest eine obere Testkontaktor parallel zum oberen Andrückelement in eine vorab festgelegte Position zurückgestellt wird. Besagte Position kann einer Lage eines zu testenden elektronischen Moduls auf der Leiterplatine entsprechen.

Vorzugsweise weist die zumindest eine Führungsausnehmung eine oder mehrere Flanken, insbesondere schräge Flanken, auf. Die schrägen Flanken, beziehungsweise Senkungen, definieren Abschnitte der Innenwand der Führungsausnehmung. Insbesondere kann die Führungsausnehmung eine erste schräge Flanke mit einem ersten Winkel aufweisen. Insbesondere kann die Führungsausnehmung eine zweite schräge Flanke mit einem zweiten Winkel aufweisen. Vorzugsweise kann die erste schräge Flanke einen ersten Winkel aufweisen und die zweite schräge Flanke einen zweiten Winkel aufweisen, wobei der erste Winkel unterschiedlich zum zweiten Winkel sein kann. Beispielsweise kann der erste Winkel der ersten schrägen Flanke in einem Intervall von etwa 20° bis 70° liegen. Insbesondere kann der erste Winkel in einem Intervall von etwa 30° bis 60° liegen. Vorteilhafterweise kann der erste Winkel in einem Intervall von etwa 40° bis 50° liegen. Weiter beispielsweise kann der zweite Winkel der zweiten schrägen Flanke in einem Intervall von etwa 40° bis 80° liegen. Insbesondere kann der zweite Winkel in einem Intervall von etwa 50° bis 70° liegen. Vorteilhafterweise kann der zweite Winkel in einem Intervall von etwa 55° bis 65° liegen. Die Ausgestaltung der Führungsausnehmung durch eine oder mehrere schräge Flanken ermöglicht eine vereinfachte Einführung des Führungsstiftes in die Führungsausnehmung.

Vorteilhafterweise können mittels besagter Flanken vorher bestimmbare Abweichungs- bzw. Verschiebungstoleranzen des oberen Andrückelements und damit des zumindest einen oberen Testkontaktors in einer horizontalen Richtung senkrecht zum zumindest einen Führungsstift, d. h. in der zx-Ebene, beim Überführen der Testvorrichtung vom Offenzustand in den Betriebszustand kompensiert werden. Zudem kann eine genaue Ausrichtung des zumindest einen oberen Testkontaktors auf dem zu kontaktierenden elektronischen Modul der Leiterplatine gewährleistet werden, da der zumindest eine Führungsstift trotz genannter Abweichungs- bzw. Verschiebungstoleranzen in die zumindest eine Führungsausnehmung eingreifen kann.

Der zumindest eine obere Testkontaktor kann eine, zwei, drei oder mehr Führungsausnehmungen in identischen oder verschiedenen Bereichen der des zumindest einen oberen Testkontaktors aufweisen.

Der zumindest eine untere Testkontaktor ist im Betriebszustand der Testvorrichtung im Wesentlichen auf einem zu testenden elektronischen Modul auf der Unterseite der Leiterplatine angeordnet, um besagtes elektronisches Modul beispielsweise mittels einer Vielzahl von Kontaktpins elektrisch zu kontaktieren. Die Unterseite ist hierbei die Seite der Leiterplatine, bei der eine Flächennormale in negative y-Richtung des Bezugskoordinatensystems weist. Der zumindest eine untere Testkontaktor kann eine Vielzahl von Kontaktpins an einer Seite oder Fläche des zumindest einen unteren Testkontaktors, die im Betriebszustand der Testvorrichtung der Unterseite der Leiterplatine gegenüberliegt, aufweisen. Diese Kontaktpins weisen demnach im Betriebszustand der Testvorrichtung zur Unterseite der Leiterplatine hin, folglich in positive y-Richtung des Bezugskoordinatensystems. Mittels der Kontaktpins kann die Leiterplatine und insbesondere ein elektronisches Modul auf der Unterseite der Leiterplatine elektrisch kontaktiert werden. Ferner kann der zumindest eine untere Testkontaktor zumindest einen Führungsstift in einem nichtleitenden Bereich der Oberseite des zumindest einen unteren Testkontaktors, die im Betriebszustand der Testvorrichtung der Unterseite der Leiterplatine gegenüberliegt, aufweisen. Der zumindest eine Führungsstift kann in einem Außenbereich der Oberseite des zumindest einen unteren Testkontaktors angeordnet sein. Der Außenbereich kann der Bereich sein, in dem sich keine Kontaktpins befinden. Der zumindest eine Führungsstift ragt sowohl im Offenzustand als auch im Betriebszustand der Testvorrichtung in positiver y-Richtung weg von der Oberseite des zumindest einen unteren Testkontaktors. Der zumindest eine Führungsstift kann als Vorsprung im zumindest einen unteren Testkontaktor ausgebildet sein, d. h. der zumindest eine untere Testkontaktor und der zumindest eine Führungsstift können als ein Bauteil ausgebildet sein. Der zumindest eine Führungsstift kann aber auch als separates Bauteil geformt sein. Beispielsweise kann auch der zumindest eine untere Testkontaktor eine der zumindest einen Führungsausnehmung ähnliche Ausnehmung aufweisen, in der das in y-Richtung untere Ende des zumindest einen Führungsstifts passgenau angeordnet werden kann. Der zumindest eine Führungsstift kann beispielsweise durch Einschrauben oder Hineinkleben in besagte Ausnehmung mit dem zumindest einen unteren Testkontaktor verbunden werden.

Die zumindest eine Führungsausnehmung und der zumindest eine Führungsstift sind derart am zumindest einen oberen Testkontaktor beziehungsweise am zumindest einen unteren Testkontaktor angeordnet, dass im Betriebszustand der Testvorrichtung der zumindest eine Führungsstift in die zumindest eine Führungsausnehmung eingreift. Das bedeutet, dass das vom zumindest einen unteren Testkontaktor in positive y-Richtung hervorragende Ende des zumindest einen Führungsstifts zum größten Teil, im Wesentlichen der Teil des Führungsstifts, der in positiver y-Richtung von der Oberseite der Leiterplatine hervorragt, in die zumindest eine Führungsausnehmung eingeführt ist. Der Querschnitt des zumindest einen Führungsstifts senkrecht zur y-Richtung kann komplementär zum Querschnitt der zumindest einen Führungsausnehmung sein. Der zumindest eine Führungsstift kann eine kleinere Querschnittsfläche als die zumindest eine Führungsausnehmung haben, so dass der zumindest eine obere Testkontaktor im Betriebszustand der Testvorrichtung in der zx-Ebene noch etwas Spiel besitzt. Alternativ kann sich der zumindest eine Führungsstift in positiver y-Richtung verjüngen oder die zumindest eine Führungsausnehmung kann sich in negativer y-Richtung verbreitern.

Vorteilhafterweise können beim Überführen der Testvorrichtung vom Offenzustand in den Betriebszustand mittels der zumindest einen Führungsausnehmung und des zumindest einen Führungsstifts herstellungsbedingte bzw. verfahrensbedingte (beispielsweise aufgrund der Steuerung durch einen Roboterarm) Fehlertoleranzen bei der räumlichen Ausrichtung des zumindest einen oberen Testkontaktors relativ zu dem zu kontaktierenden elektronischen Modul der Leiterplatine ausgeglichen werden und der zumindest eine obere Testkontaktor kann sehr genau relativ zu dem zu testenden elektronischen Modul horizontal ausgerichtet werden. Hierdurch können beispielsweise Kompensationen von Fehlertoleranzen erreicht werden, die in einem Intervall von etwa -1,0 mm bis +1 mm liegen. Insbesondere können beispielsweise erreichte Kompensationen von Fehlertoleranzen in einem Intervall von etwa -0,75 mm bis +0,75 mm liegen. Vorteilhafterweise können beispielsweise erreichte Kompensationen von Fehlertoleranzen in einem Intervall von etwa -0,5 mm bis +0,5 mm liegen.

Der zumindest eine Führungsstift kann entweder ganz oder teilweise aus einem nichtleitenden Material geformt sein. Bevorzugt ist das vom zumindest einen unteren Testkontaktor in positive y-Richtung vorspringende Ende des zumindest einen Führungsstifts aus einem nichtleitenden Material. Der zumindest eine Führungsstift kann auch aus einem leitenden Metall sein.

Der zumindest eine untere Testkontaktor kann einen, zwei, drei oder mehr Führungsstifte in identischen oder verschiedenen Bereichen des zumindest einen unteren Testkontaktors aufweisen.

Die Vielzahl von Ausrichtelementen kann zwei, drei, vier oder mehr umfassen. Sie können sich senkrecht von dem oberen Andrückelement sockelartig erstrecken, so dass die Ausrichtelemente im Betriebszustand der Testvorrichtung mit dem von dem oberen Andrückelement wegweisenden Ende der Ausrichtelemente die Oberseite der Leiterplatine berühren. Die Ausrichtelemente sind entlang einer Andrückseite des oberen Andrückelements bevorzugt paarweise gegenüberliegend angeordnet, so dass im Offenzustand der Testvorrichtung jeweils ein oberer Testkontaktor durch paarweise gegenüberliegend angeordnete Ausrichtelemente im Wesentlichen parallel zu der Andrückseite bezüglich des oberen Andrückelements vorausgerichtet oder ausgerichtet werden kann. Die oberen Ausrichtelemente können aus Metall, aus einem Kunststoff oder aus einem Elastomer sein. Die Ausrichtelemente können beispielsweise Materialien aus Aluminium und/oder PEEK beziehungsweise Polyetherketon umfassen.

Das obere Andrückelement kann der Deckel oder das Deckelelement der Testvorrichtung sein. Das obere Andrückelement kann plattenförmig ausgebildet sein. Im Betriebszustand der Testvorrichtung drückt das obere Andrückelement den zumindest einen oberen Testkontaktor gegen die Oberseite der Leiterplatine, so dass sich das obere Andrückelement im Wesentlichen parallel zu der Leiterplatine angeordnet ist. Das obere Andrückelement kann ferner mindestens eine Kontaktausnehmung aufweisen, durch die elektrische Leitungen insbesondere einer externen Spannungsquelle zu dem zumindest einen oberen Testkontaktor geführt werden und mit diesem verbunden werden können. Außerdem kann das obere Andrückelement Öffnungen wie beispielsweise Gewindebohrungen aufweisen, die sich im Betriebszustand der Testvorrichtung in positiver y-Richtung in das obere Andrückelement hinein oder durch das obere Andrückelement hindurch erstrecken.

Die Ausrichtelemente sowie das obere Andrückelement können aus demselben oder verschiedenen isolierenden, nichtleitenden oder leitenden Materialien gebildet sein.

Die Testvorrichtung umfasst eine Vielzahl von oberen Testkontaktoren und eine Vielzahl von unteren Testkontaktoren. Die Testvorrichtung kann zwei, drei oder so viele obere Testkontaktoren, wie zu testende elektronische Module auf der Oberseite der Leiterplatine vorhanden sind, aufweisen. Außerdem kann die Testvorrichtung zwei, drei oder so viele untere Testkontaktoren, wie zu testende elektronische Module auf der Unterseite der Leiterplatine vorhanden sind, aufweisen. Sowohl die Anzahl und die Anordnung der Testkontaktoren als auch die Form der Testkontaktoren kann an die Anzahl, Anordnung und Form der zu testenden elektronischen Module auf einer Leiterplatine angepasst sein.

Vorteilhafterweise können so Leiterplatinen mit beliebig vielen und beliebig angeordneten elektronischen Modulen überprüft werden, solange die Anzahl, Anordnung und Form der Testkontaktoren der Anzahl, Anordnung und Form der elektronischen Module entspricht. Beispielsweise können die elektronischen Module in einer Matrix auf der Oberseite und der Unterseite der Leiterplatine angeordnet sein. Die erfindungsgemäße Testvorrichtung ist aber nicht auf solche Leiterplatinen beschränkt. Die Leiterplatine kann insbesondere nach Testen der elektronischen Module auf Funktionstüchtigkeit weiter verarbeitet werden, z.B. können die elektronischen Module und der Bereich der Leiterplatine, an dem die Module jeweils angeordnet sind, von der (verbleibenden) Leiterplatine getrennt werden, insbesondere ausgestanzt werden.

Vorzugsweise ist der zumindest eine obere Testkontaktor rückstellfähig an dem oberen Andrückelement angeordnet, und/oder der zumindest eine untere Testkontaktor ist rückstellfähig an einem unteren Andrückelement der Testvorrichtung zum Andrücken des zumindest einen unteren Testkontaktors an den zu kontaktierenden Bereich der Unterseite der Leiterplatine angeordnet. Der zumindest eine obere Testkontaktor kann mittels einer oder mehrerer Federn in einer Richtung senkrecht zu einer Andrückfläche des oberen Andrückelements, die im Betriebszustand der Testvorrichtung der Oberseite der Leiterplatine räumlich gegenüberliegt, mit dem oberen Andrückelement verbunden sein.

Das untere Andrückelement kann der Boden oder das Bodenelement der Testvorrichtung sein. Das untere Andrückelement kann plattenförmig ausgebildet sein. Im Betriebszustand der Testvorrichtung drückt das untere Andrückelement den zumindest einen unteren Testkontaktor gegen die Unterseite der Leiterplatine, so dass sich das untere Andrückelement im Wesentlichen parallel zu der Leiterplatine angeordnet ist. Das untere Andrückelement kann ferner mindestens eine Kontaktausnehmung aufweisen, durch die elektrische Leitungen insbesondere einer externen Spannungsquelle zu dem zumindest einen unteren Testkontaktor geführt werden und mit diesem verbunden werden können. Außerdem kann das untere Andrückelement Öffnungen wie beispielsweise Gewindebohrungen aufweisen, die sich im Betriebszustand der Testvorrichtung in negativer y-Richtung in das untere Andrückelement hinein oder durch das untere Andrückelement hindurch erstrecken.

Im Betriebszustand der Testvorrichtung sind das untere Andrückelement, der zumindest eine untere Testkontaktor und die Leiterplatine im Wesentlichen parallel zueinander angeordnet. Auch der zumindest eine untere Testkontaktor kann mittels einer oder mehrerer Federn in einer Richtung senkrecht zu einer Andrückfläche des unteren Andrückelements, die im Betriebszustand der Testvorrichtung der Unterseite der Leiterplatine gegenüberliegt, mit dem unteren Andrückelement verbunden sein. Vorteilhafterweise können dadurch, dass sowohl der zumindest eine untere Testkontaktor also auch der zumindest eine obere Testkontaktor am jeweiligen unteren bzw. oberen Andrückelement federgelagert angeordnet sind, Druckkräfte des oberen und unteren Andrückelements auf die Leiterplatine im Betriebszustand der Testvorrichtung vorgegeben werden.

Vorzugsweise verjüngt sich der zumindest eine Führungsstift in der Richtung, in welcher der zumindest eine Führungsstift von dem zumindest einen unteren Testkontaktor hervorragt, radial. Der zumindest eine Führungsstift kann sich beispielsweise konisch verjüngen. Der zumindest eine Führungsstift kann auch zylindrisch hervorragen und in einem Bereich um das von dem zumindest einen unteren Testkontaktor vorspringende Ende konisch zulaufen. Besagter Bereich kann aber auch halbkugelförmig oder halbellipsoid zulaufend sein. Der zumindest eine Führungsstift kann sich ebenfalls zungenförmig verjüngen. Das bedeutet, dass der zumindest eine Führungsstift in einer seiner horizontalen Ausdehnungsrichtungen schmaler ausgebildet ist und seine Querschnittsfläche senkrecht zur y-Achse des anfänglich genannten Bezugskoordinatensystems vom zumindest einen unteren Testkontaktor weg allmählich kleiner wird.

Vorteilhafterweise kann durch eine sich verjüngende oder zulaufend vorspringende Form des zumindest einen Führungsstifts sichergestellt werden, dass, wenn die Testvorrichtung vom Offenzustand in den Betriebszustand überführt wird, beispielsweise durch Absenken des oberen Andrückelements und damit des zumindest einen oberen Testkontaktors, der zumindest eine Führungsstift in die zumindest eine Führungsausnehmung hineingleiten kann, auch wenn der zumindest eine obere Testkontaktor eine vorher bestimmbare maximale räumliche horizontale Abweichung relativ zum zu kontaktierenden elektronischen Modul der Leiterplatine aufweist.

Vorzugsweise ist das von dem zumindest einen unteren Testkontaktor hervorragende Ende des zumindest einen Führungsstifts abgerundet.

Vorzugsweise weist der zumindest eine untere Testkontaktor zumindest zwei Führungsstifte auf.

Vorteilhafterweise kann durch zumindest zwei Führungsstifte pro unterem Testkontaktor eine genauere und verlässlichere Ausrichtung des zumindest einen oberen Testkontaktors bezüglich des zu kontaktierenden elektronischen Moduls der Leiterplatine gewährleistet werden.

Vorzugsweise sind der zumindest eine Führungsstift und der zumindest eine untere Testkontaktor einteilig oder mehrteilig ausgebildet. Der zumindest eine Führungsstift und der zumindest eine untere Testkontaktor können als ein einziges Bauteil ausgebildet sein oder aber als separate Bauteile.

Vorteilhafterweise kann eine einteilige Ausbildung des zumindest einen Führungsstifts und des zumindest einen unteren Testkontaktors eine genauere Ausrichtbarkeit einer zu überprüfenden Leiterplatine mittels des zumindest einen Führungsstifts über dem zumindest einen unteren Testkontaktor herbeiführen, wohingegen eine mehrteilige Ausbildung es ermöglicht, bei der Herstellung der Testvorrichtung jeden Testkontaktor als oberen Testkontaktor mit zumindest einer Führungsausnehmung zu fertigen. Anschließend kann der zumindest eine Führungsstift mit einem Ende in die zumindest eine Führungsausnehmung gesteckt oder geschoben werden und somit ein unterer Testkontaktor geformt werden.

Vorzugsweise weist der zumindest eine obere Testkontaktor so viele Führungsausnehmungen auf, wie der zumindest eine untere Testkontaktor Führungsstifte aufweist.

Vorteilhafterweise kann durch eine gleiche Anzahl an Führungsausnehmungen wie Führungsstifte ein störungsfreies bzw. reibungsloses Kontaktieren der Oberseite der Leiterplatine durch den zumindest einen oberen Testkontaktor ermöglicht werden.

Vorzugsweise ist in dem Betriebszustand der Testvorrichtung die Querschnittsfläche des zumindest einen Führungsstifts kleiner als die Querschnittsfläche der zumindest einen Führungsausnehmung.

Vorteilhafterweise kann dadurch ermöglich werden, dass der zumindest eine Führungsstift in die zumindest eine Führungsausnehmung eingreift oder hineingleitet und so vorher bestimmbare räumliche Anordnungsungenauigkeiten des zumindest einen oberen Testkontaktors bedingt durch die räumliche Position des oberen Andrückelements relativ zum zumindest einen unteren Testkontaktor ausgeglichen werden.

Vorzugsweise weist jedes der Vielzahl von oberen Ausrichtelementen zumindest ein Federelement auf. Dieses zumindest eine Federelement kann beispielsweise eine metallische, aus einem Kunststoff oder Elastomermaterial gefertigte Druckfeder, Kolbenfeder oder Kugelkopffeder sein.

Vorteilhafterweise ist das zumindest eine Federelement so angeordnet, dass jeweils ein oberes Ausrichtelement mittels des zumindest einen Federelements die Bewegung mindestens eines oberen Testkontaktors in einer Ebene parallel zum oberen Andrückelement dämpfen kann.

Vorzugsweise ist der zumindest eine obere Testkontaktor in dem Offenzustand der Testvorrichtung mithilfe von vier oberen Ausrichtelementen in einer Ebene parallel zu dem oberen Andrückelement vorausgerichtet oder vorausrichtbar. Mit anderen Worten können um einen oberen Testkontaktor vier obere Ausrichtelemente so angeordnet sein, dass der obere Testkontaktor zwischen den vier oberen Andrückelementen in einer Ebene parallel zum oberen Andrückelement zentriert ist.

Vorzugsweise ist die Vielzahl von oberen Ausrichtelementen mit dem oberen Andrückelement ortsfest verbunden. Beispielsweise können die Ausrichtelemente Bohrungen aufweisen, in die Befestigungsbolzen angeordnet werden können, die wiederum in dafür vorgesehene Bohrungen im oberen Andrückelement angeordnet werden können, um die oberen Ausrichtelemente ortsfest mit dem oberen Andrückelement zu verbinden. Weiterhin können die Ausrichtelemente Durchgangsbohrungen aufweisen, durch die Schrauben in dafür vorgesehene Gewindebohrungen im oberen Andrückelement eingeschraubt werden können und somit die oberen Ausrichtelemente an dem oberen Andrückelement ortsfest befestigt werden können. Die Vielzahl von oberen Ausrichtelementen kann auch an das obere Andrückelement geklebt sein. Ferner kann die Vielzahl von oberen Ausrichtelementen zusammen mit dem oberen Andrückelement in einem Gussverfahren geformt sein.

Vorzugsweise weist die Testvorrichtung eine Vielzahl von unteren Ausrichtelementen auf, wobei jedes der Vielzahl von unteren Ausrichtelementen zumindest ein Federelement aufweist.

Alle obengenannten Merkmale und dazugehörigen Erläuterungen im Bezug auf die Vielzahl von oberen Ausrichtelementen und die technischen Effekte finden in analoger Weise auch auf die Vielzahl von unteren Ausrichtelementen Anwendung.

Vorzugsweise ist der zumindest eine untere Testkontaktor mithilfe von vier unteren Ausrichtelementen in einer Ebene parallel zu dem unteren Andrückelement vorausgerichtet oder vorausrichtbar.

Vorzugsweise ist die Vielzahl von unteren Ausrichtelementen mit dem unteren Andrückelement ortsfest verbunden.

Ein weiterer Aspekt der vorliegenden Erfindung betrifft eine Verwendung der oben beschriebenen Testvorrichtung. Die Verwendung umfasst die Schritte:
- Ausrichten der Leiterplatine in dem Offenzustand der Testvorrichtung mittels des zumindest einen Führungsstifts relativ zu dem zumindest einen unteren Testkontaktor,
- Kontaktieren des Bereichs der Unterseite der Leiterplatine mittels des zumindest einen unteren Testkontaktors, und
- Überführen der Testvorrichtung von dem Offenzustand in den Betriebszustand, wobei das Überführen umfasst: Absenken des oberen Andrückelements, Eingreifen des zumindest einen Führungsstifts in die zumindest eine Führungsausnehmung, und Kontaktieren des Bereichs der Oberseite der Leiterplatine mittels des zumindest einen oberen Testkontaktors.

Unter Ausrichten der Leiterplatine im Offenzustand der Testvorrichtung ist zu verstehen, dass die Leiterplatine, in der zumindest eine Öffnung, wie z. B. eine Durchgangsbohrung, durch die sich der zumindest eine Führungsstift von der Unterseite der Leiterplatine durch die Leiterplatine hindurch zur Oberseite der Leiterplatine erstrecken kann, vorgesehen ist, in die Testvorrichtung eingebracht wird, so dass der zumindest eine Führungsstift durch besagte Öffnung verläuft. Die zumindest eine Öffnung ist so angeordnet, dass mittels des zumindest einen Führungsstifts das zu testende elektronische Modul auf der Unterseite der Leiterplatine genau über dem zumindest einen unteren Testkontaktor angeordnet werden kann. Weiter wird die Leiterplatine in Kontakt mit dem zumindest einen unteren Testkontaktor gebracht, d. h. die Leiterplatine wird solange entlang des zumindest einen Führungsstifts geführt, bis das zu testende elektronische Modul auf der Unterseite der Leiterplatine exakt über dem zumindest einen unteren Testkontaktor angeordnet ist und in elektrischem Kontakt mit dem zumindest einen unteren Testkontaktor steht.

Unter Überführen vom Offen- in den Betriebszustand der Testvorrichtung ist zu verstehen, dass das obere Andrückelement im Wesentlichen in eine parallele Anordnung zur Leiterplatine und dem unteren Andrückelement gebracht wird, so dass sich die Testvorrichtung im oben beschriebenen Betriebszustand befindet. Mit anderen Worten wird das obere Andrückelement bzw. der Testvorrichtungsdeckel in Richtung der Leiterplatine bewegt bzw. auf die Leiterplatine abgesenkt, bis der von der Oberseite der Leiterplatine hervorragende Bereich des zumindest einen Führungsstifts des zumindest einen unteren Testkontaktors vollständig in die zumindest eine Führungsausnehmung des zumindest einen oberen Testkontaktors eingeführt ist. Durch das Überführen des oberen Andrückelements wird der zumindest eine obere Testkontaktor ebenfalls in elektrischen Kontakt mit dem zu testenden elektronischen Modul auf der Oberseite der Leiterplatine gebracht. Nachdem Testen bzw. Überprüfen der Leiterplatine kann die Testvorrichtung wieder vom Betriebszustand in den Offenzustand gebracht und die Leiterplatine entfernt werden.

Es folgt die Beschreibung der Figuren, die zur Veranschaulichung einer Ausführungsform des erfindungsgemäßen Gegenstands dienen. Es versteht sich, dass die Figurenbeschreibung nicht als einschränkend zu betrachten ist. Einzelne Merkmale können zu weiteren Ausführungsformen kombiniert werden.

Die in den Figuren schematisch dargestellten Elemente können einzeln in ihrer Dimensionierung und/oder Relation zueinander variiert werden. Die dargestellten Elemente weisen beispielhaft die folgenden, ungefähren Dimensionierungen auf:
Die Leiterplatine kann eine Länge (in X-Richtung) im Intervall von etwa 350 mm bis 400 mm, eine Breite (in Z-Richtung) in einem Intervall von etwa 160 mm bis 200 mm und eine Höhe (in Y-Richtung) in einem Intervall von etwa 1 mm bis 2 mm aufweisen. Insbesondere kann die Leiterplatine eine Länge in einem Intervall von etwa 370 mm bis 380 mm, eine Breite in einem Intervall von etwa 170 mm bis 190 mm und eine Höhe in einem Intervall von etwa 1,4 mm bis 1,8 mm aufweisen. Vorteilhafterweise kann die Leiterplatine eine Länge von etwa 376 mm, eine Breite von etwa 186 mm und eine Höhe von etwa 1,6 mm aufweisen.

Die Ausrichtöffnungen der Platine können einen Durchmesser in einem Intervall von etwa 1 mm bis 7 mm aufweisen. Insbesondere können die Ausrichtöffnungen einen Durchmesser in einem Intervall von etwa 3 mm bis 6 mm aufweisen. Vorteilhafterweise können die Ausrichtöffnungen der Platine ein Durchmesser von etwa 4 mm aufweisen.

Das untere und/oder das obere Andrückelement können eine Länge (in X-Richtung) in einem Intervall von etwa 350 mm bis 450 mm, eine Breite (in Z-Richtung) in einem Intervall von etwa 170 mm bis 250 mm und eine Höhe (in Y-Richtung) (ohne Einbeziehung der Vertikalanschläge) in einem Intervall von etwa 4 mm bis 10 mm aufweisen. Insbesondere können das untere und/oder das obere Andrückelement eine Länge in einem Intervall von etwa 370 mm bis 430 mm, eine Breite im Intervall von etwa 200 mm bis 220 mm und eine Höhe im Intervall von etwa 6 mm bis 8 mm aufweisen. Vorteilhafterweise können das untere und/oder das obere Andrückelement eine Länge von etwa 400 mm, eine Breite von etwa 210 mm und eine Höhe von etwa 7 mm aufweisen.

Eine Befestigungsbohrung, welche durch das untere und/oder das obere Andrückelement hindurchführt, kann einen Durchmesser in einem Intervall von etwa 0,5 mm bis 3 mm aufweisen. Insbesondere kann die Befestigungsbohrung einen Durchmesser in einem Intervall von etwa 1 mm bis 2,5 mm aufweisen. Vorteilhafterweise kann die Befestigungsbohrung einen Durchmesser in einem Intervall von etwa 1,6 mm bis 2,0 mm aufweisen.

Eine Kontaktausnehmung in dem unteren und/oder oberen Andrückelement kann eine Länge (in X-Richtung) in einem Intervall von etwa 35 mm bis 45 mm und eine Breite (in Z-Richtung) in einem Intervall von etwa 15 mm bis 25 mm aufweisen. Insbesondere kann eine Kontaktausnehmung eine Länge in einem Intervall von etwa 38 mm bis 42 mm und eine Breite in einem Intervall von etwa 18 mm bis 22 mm aufweisen. Vorteilhafterweise kann eine Kontaktausnehmung eine Länge von etwa 40 mm und eine Breite von etwa 20 mm aufweisen.

Ein auf dem unteren und/oder oberen Andrückelement angeordneter Vertikalanschlag kann eine Höhe (in Y-Richtung) in einem Intervall von etwa 3 mm bis 7 mm, eine Breite (in X-Richtung) in einem Intervall von etwa 3 mm bis 6 mm, und eine Länge (in Z-Richtung) in einem Intervall von etwa 14 mm bis 20 mm aufweisen. Insbesondere kann der Vertikalanschlag eine Höhe in einem Intervall von etwa 3,5 mm bis 6,5 mm, eine Breite in einem Intervall von etwa 3,5 mm bis 5,5 mm, und eine Länge in einem Intervall von etwa 15 mm bis 18 mm aufweisen. Vorteilhafterweise kann der Vertikalanschlag eine Höhe von etwa 5,5 mm, eine Breite von etwa 5 mm, und eine Länge von etwa 17 mm aufweisen.

Ein Ausrichtelement kann eine Höhe (in Y-Richtung) in einem Intervall von etwa 10 mm bis 14 mm aufweisen. Insbesondere kann ein Ausrichtelement eine Höhe in einem Intervall von etwa 11 mm bis 13 mm aufweisen. Vorteilhafterweise kann ein Ausrichtelement eine Höhe von etwa 12,5 mm aufweisen. Ein form- und/oder kraftschlüssig mit dem Ausrichtelement verbundener Befestigungsbolzen kann in dem Ausrichtelement angeordnet sein und eine Länge (in Y-Richtung) im Intervall von etwa 1 mm bis 6 mm aufweisen. Insbesondere kann ein Befestigungsbolzen eine Länge in einem Intervall von etwa 2 mm bis 5 mm aufweisen.

Ein elektronisches Modul kann eine Länge (in X-Richtung) in einem Intervall von etwa 50 mm bis 80 mm und eine Breite (in Z-Richtung) in einem Intervall von etwa 10 mm bis 20 mm aufweisen. Insbesondere kann ein elektronisches Modul eine Länge in einem Intervall von etwa 60 mm bis 70 mm und eine Breite in einem Intervall von etwa 12 mm bis 18 mm aufweisen.

Ein Testkontaktor kann eine oktogonale Grundform aufweisen. Die oktogonale Grundform des Testkontaktors kann eine lange Seitenkante mit einer Länge in einem Intervall von etwa 40 mm bis 50 mm, eine kurze Seitenkante mit einer Länge in einem Intervall von etwa 10 mm bis 30 mm, und eine Höhe in einem Intervall von etwa 1 mm bis 10 mm in Y-Richtung aufweisen. Insbesondere kann die oktogonale Grundform des Testkontaktors eine lange Seitenkante mit einer Länge in einem Intervall von etwa 42 mm bis 48 mm, eine kurze Seitenkante mit einer Länge in einem Intervall von etwa 14 mm bis 26 mm, und eine Höhe in einem Intervall von etwa 2 mm bis 9 mm aufweisen.

Eine Rückstellfederöffnung kann einen Durchmesser in einem Intervall von etwa 1 mm bis 10 mm aufweisen. Insbesondere kann eine Rückstellfederöffnung einen Durchmesser in einem Intervall von etwa 4 mm bis 8 mm aufweisen. Vorteilhafterweise kann die Rückstellfederöffnung einen Durchmesser von etwa 5 mm aufweisen. Eine Rückstellfeder kann eine zur Maßnorm DIN 2076 konforme Feder sein. Insbesondere kann die Rückstellfeder eine Druckfeder sein.

Ein Führungsstift kann eine Länge (in Y-Richtung) in einem Intervall von etwa 10 mm bis 20 mm und einen über diese Länge hinweg variierenden Durchmesser in einem Intervall von etwa 0,5 mm bis 6 mm aufweisen. Insbesondere kann ein Führungsstift eine Länge in einem Intervall von etwa 12 mm bis 18 mm und einen über diese Länge hinweg variierenden Durchmesser in einem Intervall von etwa 1 mm bis 5 mm aufweisen. Vorteilhafterweise kann der Führungsstift eine Länge von etwa 16,8 mm, einen maximalen Durchmesser von etwa 4 mm und einen minimalen Durchmesser von etwa 1,2 mm aufweisen.

Es zeigen:
- Figur 1a: eine isometrische Ansicht einer schematischen Darstellung der Testvorrichtung in einem Offenzustand ohne Leiterplatine;
- Figur 1b: eine isometrische Ansicht einer schematischen Darstellung der Testvorrichtung in einem Offenzustand mit Leiterplatine;
- Figur 1c: eine isometrische Ansicht einer schematischen Darstellung der Testvorrichtung im Betriebszustand;
- Figur 2a: einen Längsschnitt der Testvorrichtung im Betriebszustand;
- Figur 2b: eine vergrößerte Ansicht eines Längsschnitts der Testvorrichtung im Betriebszustand;
- Figur 2c: eine vergrößerte Ansicht eines Längsschnitts durch einen Führungsstift innerhalb einer Führungsausnehmung;
- Figur 3: eine vergrößerte Draufsicht der Testvorrichtung im Betriebszustand ohne oberes Andrückelement.

Hilfsweise sind alle gezeigten Figuren mit einem kartesischen Koordinatensystem ausgestattet, auf das sich alle Richtungsangeben beziehen. Insbesondere die Angaben "oben" und "unten" bzw. "vertikal" werden an der y-Achse gemessen, während die Angaben "längs" bzw. "quer" sich auf die x-Achse bzw. z-Achse beziehen und die Angabe "horizontal" sich auf die zx-Ebene bezieht.

Der Einfachheit und klaren Darstellung halber ist bzw. sind in den Figuren bei sich wiederholenden Komponenten lediglich eine, zwei oder drei der Komponenten exemplarisch mit einem Bezugszeichen versehen.

In den Figuren sind lediglich die für die erfindungsgemäße Testvorrichtung wesentlichen Merkmale gezeigt. Weitere externe Komponenten wie Andrückmechanismen, Hebelmechanismen, Steuereinheiten, elektrische Leitungen, etc. sind nicht gezeigt.

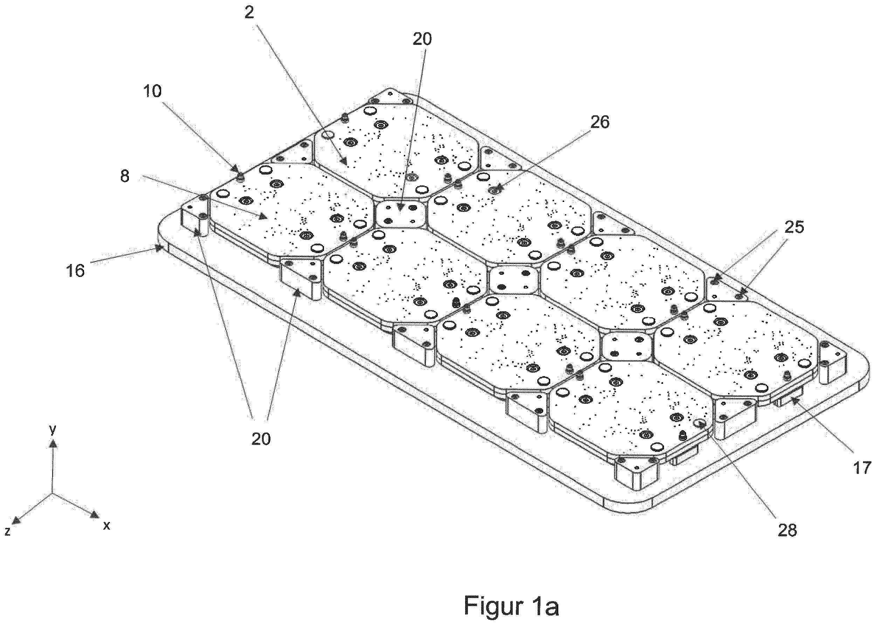

**Figur 1a** zeigt eine isometrische Ansicht einer schematischen Darstellung der Testvorrichtung in einem Offenzustand ohne Leiterplatine. In Figur 1a sind acht untere Testkontaktoren 8 in einer Matrix an einem flächig, mit abgerundeten Ecken ausgebildeten Vorrichtungsboden als unteres Andrückelement 16 angeordnet. Jeder der acht unteren Testkontaktoren 8 ist im Querschnitt senkrecht zur y-Achse als regelmäßiges Oktagon ausgebildet und weist zwei sich gegenüberliegende Metallpins als Führungsstifte 10 auf. Diese Metallpins springen in positiver y-Richtung des angegebenen Koordinatensystems von der Oberseite der unteren Testkontaktoren 8 vor. Weiterhin weisen die unteren Testkontaktoren in einem Rechteck angeordnete runde Vertikalanschlagsfedern 28 auf. Diese Vertikalanschlagsfedern 28 können beispielsweise aus einem Elastomermaterial geformte Druckfedern sein, welche um den Bereich, in dem sich die Kontaktpins (hier nicht gezeigt) der jeweiligen unteren Testkontaktoren 8 befinden, herum an den jeweiligen unteren Testkontaktor 8 anvulkanisiert sein können. Diese Vertikalanschlagsfedern 28 sollen ein zu starkes Andrücken der Testkontaktoren an die Unterseite einer Leiterplatine, wodurch die Kontaktpins beschädigt werden könnten, vermeiden.

Ferner sind in Figur 1a Öffnungen oder Aufnahmen gezeigt, die ebenfalls in einem Rechteck analog zu den obengenannten Vertikalanschlagsfedern 28 in jedem unteren Testkontaktor 8 angeordnet sind. Diese Öffnungen oder Aufnahmen nehmen die später gezeigten Rückstellfedern 26, mittels derer die unteren Testkontaktoren 8 mit dem unteren Andrückelement 16 elastisch verbunden sind, auf und erstrecken sich in vertikaler Richtung von der Unterseite der unteren Testkontaktoren 8 durch die unteren Testkontaktoren 8 hindurch zur Oberseite der unteren Testkontaktoren 8.

Wie in Figur 1a dargestellt, ist jeder untere Testkontaktor 8 von jeweils vier sockelartigen Elementen umgeben, nämlich den unteren Ausrichtelementen 20, welche die unteren Testkontaktoren 8 horizontal in einer vorher festlegbaren Position ausrichten.

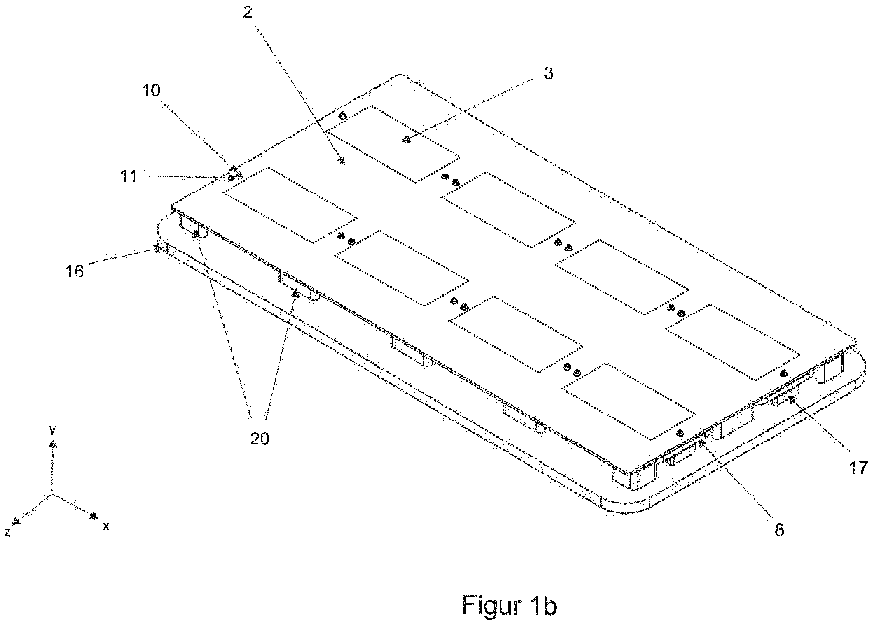

**Figur 1b** zeigt eine isometrische Ansicht der schematischen Darstellung der Testvorrichtung aus Figur 1a. Eine Leiterplatine 2 mit acht in einer Matrix angeordneten elektronischen Modulen 3 (hier durch gepunktete Linien angedeutet) sowohl auf der Oberseite als auch auf der Unterseite der Leiterplatine 2 ist auf eine der Anzahl von elektronischen Modulen 3 auf der Unterseite der Leiterplatine 2 entsprechende Anzahl von unteren Testkontaktoren 8 positioniert. Die Leiterplatine 2 weist jeweils zwei zueinander parallele Reihen von jeweils acht Ausrichtöffnungen 11, die beispielsweise Bohrungen durch die Leiterplatine 2 oder Aussparungen bei der Fertigung der Leiterplatine 2 darstellen können, in periodischen Abständen in Längsrichtung der Leiterplatine 2 auf. Zwischen je einem in Längsrichtung der Leiterplatine 2 gegenüberliegenden Paar Ausrichtöffnungen 11 befindet sich jeweils ein elektronisches Modul 3 der Leiterplatine 2. Die Leiterplatine 2 ist mithilfe der Ausrichtöffnungen 11 und mittels von sechzehn Führungsstiften 10 über den unteren Testkontaktoren 8 angeordnet und ausgerichtet. Die Führungsstifte 10 erstrecken sich in vertikaler Richtung von der Unterseite der Leiterplatine 2 zur Oberseite der Leiterplatine 2, so dass ein Teil des oberen Endes der Führungsstifte 10 über die Oberseite der Leiterplatine 2 hinausragt.

Ferner ist in Figur 1b gezeigt, dass die Testvorrichtung von unten, d. h. in positiver y-Richtung, in horizontaler Richtung, d. h. in einer Richtung in der zx-Ebene, durch einen flächig bzw. plattenförmig ausgebildeten Vorrichtungsboden bzw. ein flächig bzw. plattenförmig ausgebildetes unteres Andrückelement 16 begrenzt ist. Das untere Andrückelement 16 weist abgerundete Ecken auf und ist beispielsweise aus einem isolierenden Material geformt. Ferner weist das untere Andrückelement 16 zwei Reihen von unteren parallelen Vertikalanschlägen 17 auf, die den minimalen vertikalen Abstand des unteren Andrückelements 16 zur Unterseite der unteren Testkontaktoren 8 festlegen. Die unteren Vertikalanschläge 17 können beispielsweise aus einem Elastomermaterial oder einem anderen isolierenden Material sein. Das untere Andrückelement 16 und die unteren Vertikalanschläge 17 können als eine einzige aus demselben Material oder als mehrere beispielsweise durch Verkleben miteinander fest verbundene Komponenten ausgebildet sein.

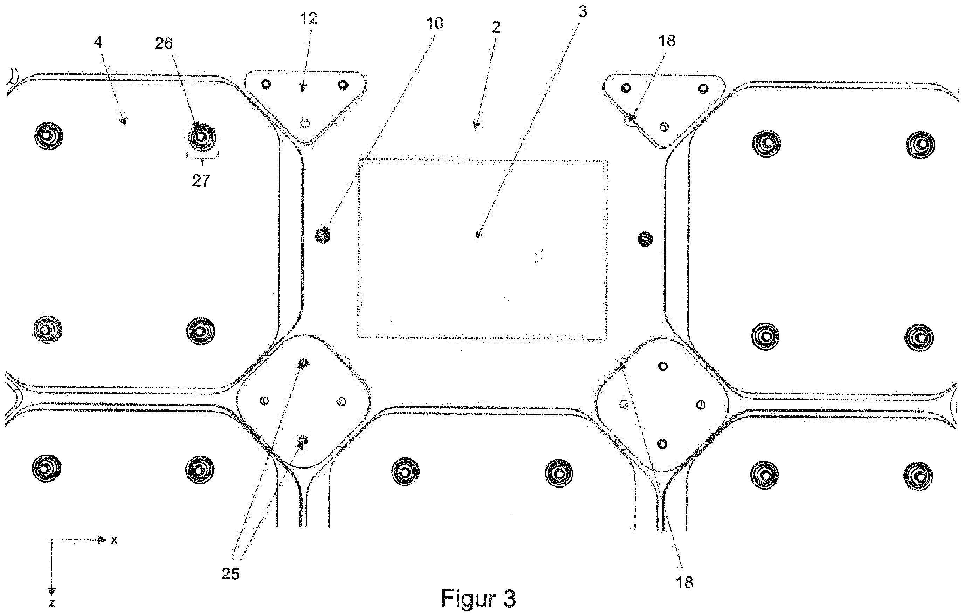

Außerdem sind in Figur 1b eine Reihe von unteren Ausrichtelementen 20 gezeigt, die dazu dienen, die unteren Testkontaktoren 8 horizontal vorzuzentrieren und gegebenenfalls mittels Federn (hier nicht gezeigt, siehe Figur 3), die horizontal ins Innere der Testvorrichtung gerichtet sind, Relativbewegungen der unteren Testkontaktoren 8 parallel zum unteren Andrückelement 16 und einer eingesetzten Leiterplatine 2 zuzulassen. Hierfür ist jeweils ein unterer Testkontaktor 8 horizontal von vier unteren Ausrichtelementen umgeben.

Die unteren Ausrichtelemente 20 sind in Längsrichtung, d. h. in x-Richtung, in drei parallelen Reihen mit jeweils demselben Abstand in z-Richtung angeordnet. Zwei der Reihen sind in gegenüberliegenden Randbereichen des unteren Andrückelements 16 angeordnet und eine Reihe ist in Längsrichtung in einem Mittelbereich des unteren Andrückelements 16 angeordnet.

Die unteren Ausrichtelemente 20 sind fest mit dem unteren Andrückelement 16 verbunden. Beispielsweise können die Ausrichtelemente 20 in Vertikalrichtung mit dem unteren Andrückelement 16 mittels Schrauben verschraubt sein oder mittels von Schraubbolzen, deren eines Ende in die unteren Ausrichtelemente 20 geschraubt ist und deren anderes Ende in dafür vorgesehene Bohrungen im unteren Andrückelement 16 gesteckt ist, verbunden sein.

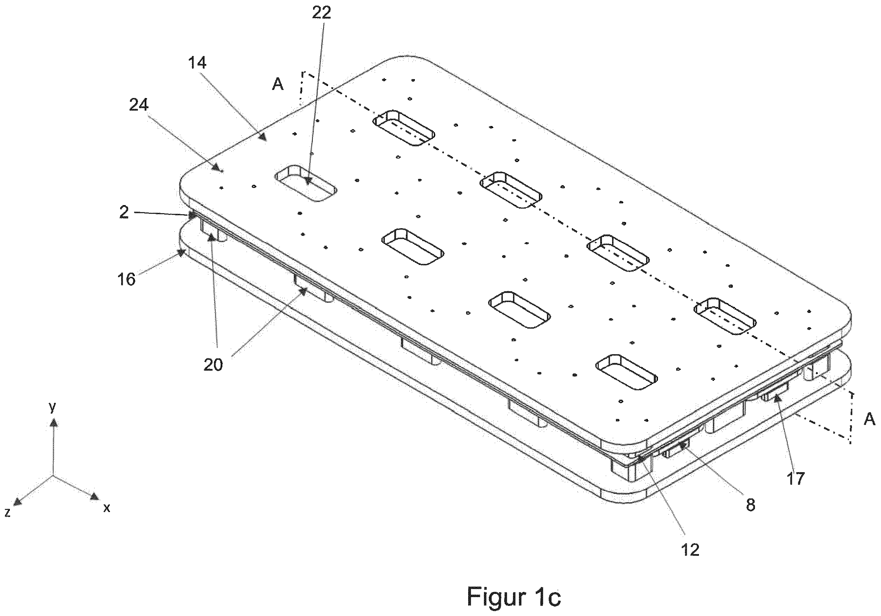

**Figur 1c** zeigt die gleiche isometrische Ansicht der schematischen Darstellung der Testvorrichtung wie in Figur 1a und 1b. In Figur 1c ist die Testvorrichtung im Betriebszustand gezeigt, Im Betriebszustand weist die Testvorrichtung oben einen flächig bzw. plattenförmig ausgebildeten Vorrichtungsdeckel 14 bzw. ein flächig bzw. plattenförmig ausgebildetes oberes Andrückelement 14 auf. Das obere Andrückelement 14 weist abgerundete Ecken auf. Ferner weist das obere Andrückelement 14 in einer Matrix angeordnete Kontaktausnehmungen 22, durch die in Vertikalrichtung externe elektrische Kontakte zu den oberen Testkontaktoren 4 geführt werden können, sowie in einem periodischen Muster um die Kontaktausnehmungen 22 angeordnete Befestigungsbohrungen 24, mittels derer analog zu dem unteren Andrückelement 16 eine zu den unteren Ausrichtelementen 20 relativ zur Leiterplatine 2 symmetrisch angeordnete Reihe von oberen Ausrichtelementen 12 mit dem oberen Andrückelement 14 fest verbunden sind, auf.

Es versteht sich, dass alle beschriebenen strukturellen sowie funktionalen Merkmale aller "oberen Komponenten" der Testvorrichtung, auch wenn nicht explizit erwähnt, den der "unteren Komponenten" der Testvorrichtung und umgekehrt entsprechen können. In der gezeigten Ausführungsform ist die Testvorrichtung bis auf wenige im Folgenden explizit erwähnte Ausnahmen nämlich im Betriebszustand symmetrisch zur Leiterplatine 2 ausgebildet.

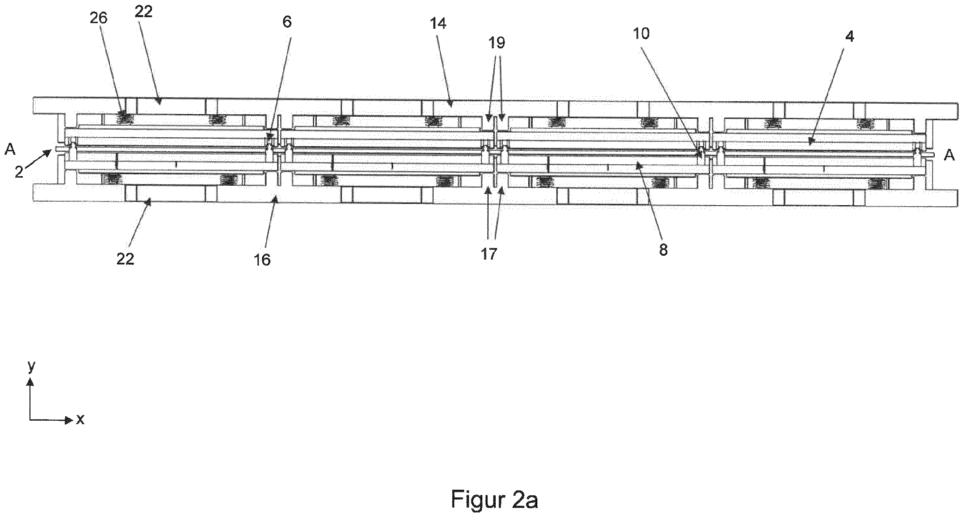

**Figur 2a** zeigt einen Längsschnitt durch die in Figur 1c angedeutete Ebene A-A in der xy-Ebene. Der Längsschnitt verläuft entlang einer der parallel zueinander in Längsrichtung angeordneten Reihen von Führungsstiften 10 und teilt so eine der Reihen von elektronischen Modulen 3 der Leiterplatine 2 mittig. Der Längsschnitt zeigt im Wesentlichen 4 elektronische Module 3 der Leiterplatine 2, die jeweils von einem oberen Testkontaktor 4 und einem unteren Testkontaktor 8 elektrisch kontaktiert werden. Die Leiterplatine 2 befindet sich in einer "Sandwich"-Anordnung zwischen den oberen Testkontaktoren 4 und den unteren Testkontaktoren 8, wobei sowohl die oberen Testkontaktoren 4 als auch die unteren Testkontaktoren 8 mittels jeweils vier Rückstellfedern 26 (im Längsschnitt sind nur zwei zu sehen) elastisch mit dem oberen Andrückelement 14 bzw. dem unteren Andrückelement 16 elastisch verbunden sind. Diese Rückstellfedern 26 können Federbolzen bzw. Federschrauben darstellen, die in die dafür vorgesehenen Befestigungsbohrungen 24 wie in Figur 1c (hier nicht gezeigt) gesteckt bzw. geschraubt werden können. Die Rückstellfedern 26 sind entlang des Längsschnitts in einer Linie mit den Führungsstiften 10 angeordnet. Die Rückstellfedern 26, die die unteren Testkontaktoren 8 mit dem unteren Andrückelement 14 verbinden, sind in Längsrichtung weiter voneinander weg angeordnet als die Rückstellfedern 26, die die oberen Testkontaktoren mit dem oberen Andrückelement 14 verbinden. Dies soll die Stabilität der Testvorrichtung in Vertikalrichtung beim Andrücken des unteren Andrückelements 16 und des oberen Andrückelements 14 gegen die Leiterplatine 2 erhöhen und verhindern, dass die unteren Testkontaktoren 8 gegen die Längsrichtung verkippen. Der Bolzen- bzw. Schraubenteil der Rückstellfedern 26 erstreckt sich vom oberen Andrückelement 14 bzw. vom unteren Andrückelement 16 in Vertikalrichtung über in den jeweiligen Testkontaktoren vorgesehenen Rückstellfederöffnungen 27 (hier nicht gezeigt, siehe Figur 3) in die Testkontaktoren hinein.

Außerdem wird in Figur 2a gezeigt, wie jeder Testkontaktor 4, 8 von einem Paar Vertikalanschlägen 17, 19 entlang der Längsrichtung in vertikaler Richtung von oben bzw. von unten berührt wird. Im in Figur 2a dargestellten Längsschnitt sind die Vertikalanschläge 17, 19 aus dem jeweilige oberen Andrückelement 14 bzw. unteren Andrückelement 16 herausgebildet, so dass der obere Vertikalanschlag 19 vom oberen Andrückelement 14 in Vertikalrichtung nach unten im Querschnitt rechteckig vorspringt und der untere Vertikalanschlag 17 vom unteren Andrückelement 16 in Vertikalrichtung nach oben im Querschnitt rechteckig vorspringt.

Die Vertikalanschläge 17, 19 können auch getrennt von den Andrückelementen 14, 16 geformte Bauteile sein. Beispielsweise können die Vertikalanschläge 17, 19 aus einem Elastomer geformt sein und mit dem jeweiligen Andrückelement 14, 16 verklebt bzw. auf das jeweilige Andrückelement 14, 16 vulkanisiert sein.

Wie in Figur 2a deutlich gemacht wird, greifen die Führungspins oder Führungsstifte 10 im Betriebszustand in die dafür vorgesehenen Führungsausnehmungen 6 in den oberen Testkontaktoren 4 ein.

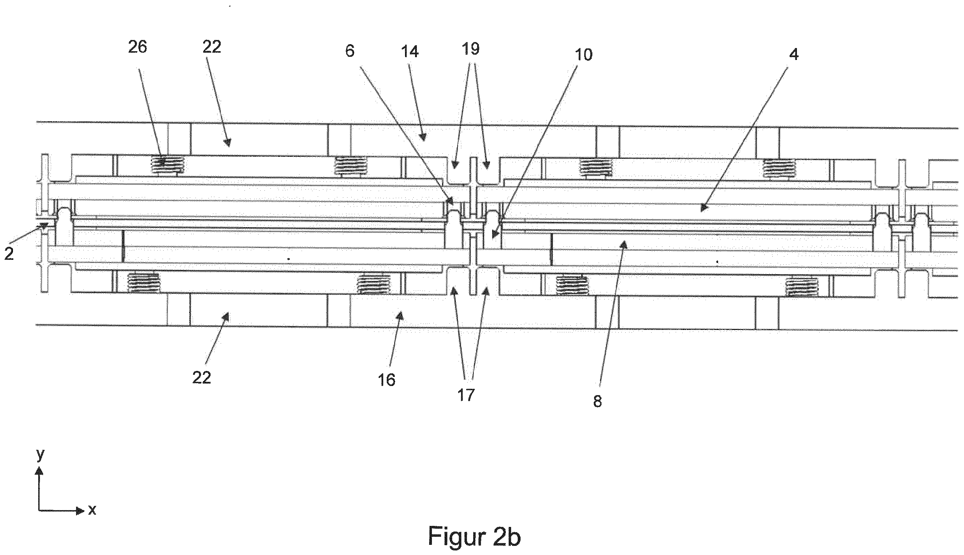

**Figur 2b** zeigt eine vergrößerte Darstellung des Längsschnitts aus Figur 2a. Der Längsschnitt zeigt im Wesentlichen zwei elektronische Module 3 der Leiterplatine 2, die jeweils von einem oberen Testkontaktor 4 und einem unteren Testkontaktor 8 elektrisch kontaktiert werden.

Wie in der Detailansicht von Figur 2b gezeigt wird, greifen die Führungspins oder Führungsstifte 10 im Betriebszustand in die dafür vorgesehenen Führungsausnehmungen 6 in den oberen Testkontaktoren 4 ein. Die gezeigten Führungsstifte 10 verjüngen sich in vertikaler Richtung kuppelartig bzw. stufenförmig, wobei die Stufen abgerundet sind. So wird sichergestellt, dass die Führungsstifte 10, wenn die Testvorrichtung vom Offenzustand in den Betriebszustand befördert wird, in die Führungsausnehmungen 6 auch bei vorher bestimmbaren vorrichtungsbedingten horizontalen Auslenkungen des oberen Andrückelements 14 relativ zur Leiterplatine 2 einhaken und nach und nach in die Führungsausnehmung 6 hineinrutschen bzw. -gleiten. Die Führungsausnehmungen 6 können sich, wie im Längsschnitt dargestellt, außerdem nach unten hin verbreitern bzw. schräge Flanken aufweisen. Diese Verbreiterung entspricht vorher bestimmbaren systematischen horizontalen Abweichungen oder Bewegungen der oberen Testkontaktoren 4 beim Schließen bzw. Überführen der Testvorrichtung vom Offen- in den Betriebszustand und ermöglicht zusätzlich einen Ausgleich system- und/oder betriebsbedingter Toleranzen der Testvorrichtung beim Kontaktieren der Leiterplatine 2 durch die oberen Testkontaktoren 4.

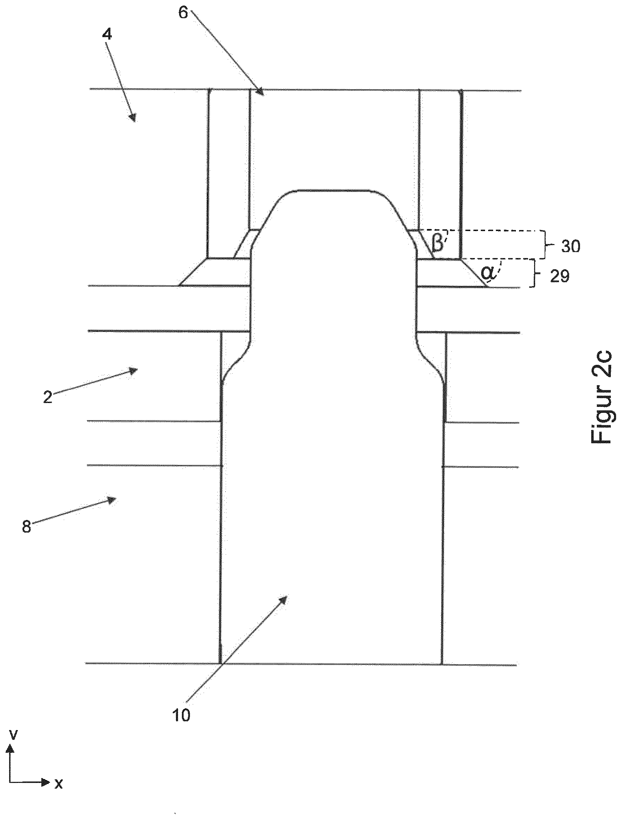

**Figur 2c** zeigt eine vergrößerte Ansicht eines Längsschnitts durch einen Führungsstift 10 innerhalb einer Führungsausnehmung 6. Figur 2c veranschaulicht exemplarisch die erste schräge Flanke 29 und die zweite schräge Flanke 30 der Führungsausnehmung 6. Die erste schräge Flanke 29 und die zweite schräge Flanke 30 definieren jeweilig einen Abschnitt der Innenwand der Führungsausnehmung 6. Hierbei weist die erste schräge Flanke 29 einen ersten Winkel α auf. Die zweite schräge Flanke 30 weist einen zweiten Winkel β auf. Die Winkel α und β können zueinander unterschiedlich sein. Die schrägen Flanken innerhalb der Führungsausnehmung sind derart bemaßt, dass beim Einführen des Führungsstifts eine vereinfachte Zentrierung des Führungsstifts 10 innerhalb der Führungsausnehmung 6 ohne übermäßigen Kraftaufwand ermöglicht wird. Hierfür kann die Führungsausnehmung 6 zum Führungsstift 10 derart dimensioniert sein, dass zwischen dem Führungsstift 10 und den Innenwänden der Führungsausnehmung 6 ausreichend Spiel vorhanden ist.

**Figur 3** zeigt eine vergrößerte Draufsicht der schematischen Darstellung der Testvorrichtung im Betriebszustand aus Figur 1c ohne oberes Andrückelement 14. Figur 3 soll exemplarisch die Anordnung und Funktionsweise der oberen Ausrichtelemente 12 veranschaulichen. Natürlich gelten die folgenden Ausführungen analog für die unteren Ausrichtelemente 20. Die Draufsicht zeigt die oberen Ausrichtelemente 12 (äquivalent können es auch die unteren Ausrichtelemente 20 sein), die in der gezeigten Ausführungsform in drei zueinander parallelen Reihen in Längsrichtung angeordnet sind. Zum besseren Verständnis ist in Figur 3 ein oberer Testkontaktor 4 nicht gezeigt, so dass der Blick auf die darunterliegende Leiterplatine 2, ein zu testendes elektronisches Modul 3 (durch gepunktete Linien angedeutet) und die entgegen der Blickrichtung (Blickrichtung in negative y-Richtung) hervorragenden Führungsstifte 10 frei ist. Es ist gezeigt, dass je ein oberer Testkontaktor 4 von vier in einem Viereck angeordneten oberen Ausrichtelementen 12 umgeben sein kann. Die Anzahl von oberen Ausrichtelementen 12 hängt von der Form der oberen Testkontaktoren 4 ab. Jedes der oberen Ausrichtelemente 12 weist mindestens eine Kugelkopffeder als Federelement 18 auf, welche aus den Ausrichtelementen in Richtung der Testkontaktoren hervorragen. Die Ausrichtelemente in den Eckbereichen der Testvorrichtung weisen ein Federelement 18 auf, die Ausrichtelemente entlang der Randbereiche der Testvorrichtung weisen zwei in einem 90° Winkel zueinander angeordnete Federelemente 18 auf, und die Ausrichtelemente innerhalb der Testvorrichtung weisen vier sternförmig angeordnete Federelemente 18 auf, wobei benachbarte Federelemente 18 der vier sternförmig angeordneten Federelemente einen 90° Winkel zueinander haben. Mittels der Federelemente 18 werden die Testkontaktoren im Offenzustand der Testvorrichtung wieder in ihre Ausgangslage gebracht und erneut ausgerichtet bzw. zwischen den Ausrichtelementen zentriert, sollte es zu einer horizontalen Relativbewegung der Testkontaktoren bezüglich des entsprechenden Andrückelements beim Überführen in den Betriebszustand und dem Einfädeln des Führungsstifte 10 in die Führungsausnehmungen 6 kommen, weil sich beispielsweise das obere Andrückelement 14 aufgrund einer bekannten systematischen räumlichen Fehlertoleranz beim Schließen der Testvorrichtung horizontal verschoben hat. Die oberen Ausrichtelemente 12 sind mittels der gezeigten Befestigungsbolzen 25 am oberen Andrückelement befestigt.

Figur 3 zeigt ebenfalls die Rückstellfedern 26 und die Rückstellfederöffnungen 27. Die Rückstellfederöffnungen 27 sind hierbei in der gezeigten Draufsicht zwar komplementär zu den Federbolzen bzw. -schrauben der Rückstellfedern 26 geformt, der Innenradius der Rückstellfederöffnungen 27 ist jedoch größer als der Außenradius der Federbolzen bzw. -schrauben der Rückstellfedern 26, wodurch eine schwimmende Lagerung der Testkontaktoren in horizontaler Richtung ermöglicht wird. Der Innenradius der Rückstellfederöffnungen 27 kann ebenfalls so gewählt werden, dass horizontale Anordnungstoleranzen relativ zu den zu testenden elektronischen Modulen 3 der oberen Testkontaktoren 4 beim Überführen der Testvorrichtung vom Offenzustand in den Betriebszustand ausgeglichen werden können. Durch die schwimmende Lagerung der oberen Testkontaktoren lassen sich die oberen Testkontaktoren 4 horizontal um einen vorher festgelegten Radius verschieben, so dass ein Eingreifen des Führungsstifts 10 in die Führungsausnehmung 6 sichergestellt ist, die oberen Testkontaktoren 4 horizontal den zu kontaktierenden elektronischen Modulen 3 der Leiterplatine 2 genau ausgerichtet werden können und die oberen Testkontaktoren 4 die elektronischen Module 3 kontaktieren können.

Es versteht sich, dass die erfindungsgemäße Testvorrichtung nicht auf die in den Figuren exemplarisch dargestellte hoch symmetrische Ausführungsform beschränkt ist.

### Bezugszeichenliste

- 2: Leiterplatine
- 3: elektronisches Modul
- 4: oberer Testkontaktor
- 6: Führungsausnehmung
- 8: unterer Testkontaktor
- 10: Führungsstift
- 11: Ausrichtöffnung
- 12: oberes Ausrichtelement
- 14: oberes Andrückelement
- 16: unteres Andrückelement
- 17: unterer Vertikalanschlag
- 18: Federelement
- 19: oberer Vertikalanschlag
- 20: unteres Ausrichtelement
- 22: Kontaktausnehmung
- 24: Befestigungsbohrung
- 25: Befestigungsbolzen
- 26: Rückstellfeder
- 27: Rückstellfederöffnung
- 28: Vertikalanschlagsfeder
- 29: Erste schräge Flanke
- 30: Zweite schräge Flanke

## Patentansprüche

1. Testvorrichtung, insbesondere für das Testen elektronischer Module auf einer Leiterplatine (2), umfassend:
- zumindest einen oberen Testkontaktor (4) zum elektrischen Kontaktieren eines Bereichs einer Oberseite einer Leiterplatine (2), wobei der zumindest eine obere Testkontaktor (4) zumindest eine Führungsausnehmung (6) aufweist,
- zumindest einen unteren Testkontaktor (8) zum elektrischen Kontaktieren eines Bereichs einer Unterseite der Leiterplatine (2), wobei der zumindest eine untere Testkontaktor (8) zumindest einen Führungsstift (10) zum Ausrichten der Leiterplatine (2) relativ zu dem zumindest einen unteren Testkontaktor (8) aufweist,
wobei der zumindest eine Führungsstift (10) von dem zumindest einen unteren Testkontaktor (8) hervorragt,
wobei in einem Betriebszustand der Testvorrichtung der zumindest eine Führungsstift (10) in die zumindest eine Führungsausnehmung (6) eingreift, wodurch der zumindest eine obere Testkontaktor (4) relativ zu der Leiterplatine (2) und dem zumindest einen unteren Testkontaktor (8) ausgerichtet ist,
- ein oberes Andrückelement (14) zum Andrücken des zumindest einen oberen Testkontaktors (4) an den zu kontaktierenden Bereich der Oberseite der Leiterplatine (2),
**dadurch gekennzeichnet, dass** die Testvorrichtung zudem eine Vielzahl von oberen Ausrichtelementen (12) zum Ausrichten des zumindest einen oberen Testkontaktors (4) in einem Offenzustand der Testvorrichtung relativ zu dem oberen Andrückelement (14) aufweist, wobei die Testvorrichtung eine Vielzahl der genannten oberen Testkontaktoren (4) und eine Vielzahl der genannten unteren Testkontaktoren (8) umfasst.

2. Testvorrichtung gemäß Anspruch 1, wobei sich der zumindest eine Führungsstift (10) in der Richtung, in welcher der zumindest eine Führungsstift (10) von dem zumindest einen unteren Testkontaktor (8) hervorragt, radial verjüngt, und/oder
wobei die zumindest eine Führungsausnehmung (6) schräge Flanken aufweist.

3. Testvorrichtung gemäß einem der Ansprüche 1 bis 2, wobei der zumindest eine Führungsstift (10) zungenförmig ausgebildet ist, und/oder
wobei das von dem zumindest einen unteren Testkontaktor (8) hervorragende Ende des zumindest einen Führungsstifts (10) abgerundet ist, und/oder
wobei der zumindest eine Führungsstift (10) und der zumindest eine untere Testkontaktor (8) einteilig oder mehrteilig ausgebildet sind.

4. Testvorrichtung gemäß einem der Ansprüche 1 bis 3, wobei der zumindest eine untere Testkontaktor (8) zumindest zwei Führungsstifte aufweist.

5. Testvorrichtung gemäß einem der Ansprüche 1 bis 4, wobei der zumindest eine obere Testkontaktor (4) so viele Führungsausnehmungen aufweist, wie der zumindest eine untere Testkontaktor (8) Führungsstifte aufweist.

6. Testvorrichtung gemäß einem der Ansprüche 1 bis 5, wobei jedes der Vielzahl von oberen Ausrichtelementen (12) zumindest ein Federelement (18) aufweist.

7. Testvorrichtung gemäß einem der Ansprüche 1 bis 6, wobei der zumindest eine obere Testkontaktor (4) in dem Offenzustand der Testvorrichtung mithilfe von vier oberen Ausrichtelementen (12) in einer Ebene parallel zu dem oberen Andrückelement (14) vorausgerichtet ist oder vorausrichtbar ist.

8. Testvorrichtung gemäß einem der Ansprüche 1 bis 7, wobei die Vielzahl von oberen Ausrichtelementen (12) mit dem oberen Andrückelement (14) ortsfest verbunden ist.

9. Testvorrichtung gemäß einem der Ansprüche 1 bis 8, wobei die Testvorrichtung eine Vielzahl von unteren Ausrichtelementen (20) aufweist, wobei jedes der Vielzahl von unteren Ausrichtelementen (20) zumindest ein Federelement (18) aufweist,
wobei der zumindest eine untere Testkontaktor (8) mithilfe von vier unteren Ausrichtelementen (20) in einer Ebene parallel zu einem unteren Andrückelement (16) vorausgerichtet sein kann oder vorausrichtbar sein kann,
wobei die Vielzahl von unteren Ausrichtelementen (20) mit dem unteren Andrückelement (16) ortsfest verbunden sein kann.

10. Verwendung der Testvorrichtung zum Testen elektronischer Module auf einer Leiterplatine (2) gemäß einem der Ansprüche 1 bis 9, wobei die Verwendung die Schritte umfasst:
Ausrichten der Leiterplatine (2) in dem Offenzustand der Testvorrichtung mittels des zumindest einen Führungsstifts (10) relativ zu dem zumindest einen unteren Testkontaktor (8),
Kontaktieren des Bereichs der Unterseite der Leiterplatine (2) mittels des zumindest einen unteren Testkontaktors (8), und
Überführen der Testvorrichtung von dem Offenzustand in den Betriebszustand, wobei das Überführen umfasst:
Absenken des oberen Andrückelements (14),
Eingreifen des zumindest einen Führungsstifts (10) in die zumindest eine Führungsausnehmung (6), und
Kontaktieren des Bereichs der Oberseite der Leiterplatine (2) mittels des zumindest einen oberen Testkontaktors (4).

## Claims

1. Test device, in particular for testing electronic modules on a printed circuit board (2), comprising:
- at least one upper test contactor (4) for electrically contacting a region of an upper side of a printed circuit board (2), wherein the at least one upper test contactor (4) has at least one guide recess (6),
- at least one lower test contactor (8) for electrically contacting a region of a lower side of the printed circuit board (2), wherein the at least one lower test contactor (8) has at least one guide pin (10) for aligning the printed circuit board (2) relative to the at least one lower test contactor (8),
wherein the at least one guide pin (10) protrudes from the at least one lower test contactor (8),
wherein in an operating state of the test device the at least one guide pin (10) engages the at least one guide recess (6), whereby the at least one upper test contactor (4) is aligned relative to the printed circuit board (2) and the at least one lower test contactor (8),
- an upper pressing element (14) for pressing the at least one upper test contactor (4) onto the region of the upper side of the printed circuit board (2) to be contacted,
**characterised in that** the test device furthermore has a plurality of upper alignment elements (12) for aligning the at least one upper test contactor (4) in an open state of the test device relative to the upper pressing element (14), wherein the test device comprises a plurality of said upper test contactors (4) and a plurality of said lower test contactors (8).

2. Test device according to claim 1, wherein the at least one guide pin (10) tapers radially in the direction in which the at least one guide pin (10) protrudes from the at least one lower test contactor (8), and/or
wherein the at least one guide recess (6) has inclined flanks.

3. Test device according to one of claims 1 to 2, wherein the at least one guide pin (10) is designed to be tongue-shaped, and/or
wherein the end of the at least one guide pin (10) protruding from the at least one lower test contactor (8) is rounded, and/or
wherein the at least one guide pin (10) and the at least one lower test contactor (8) are formed in one or multiple parts.

4. Test device according to any one of claims 1 to 3, wherein the at least one lower test contactor (8) has at least two guide pins.

5. Test device according to any one of claims 1 to 4, wherein the at least one upper test contactor (4) has as many guide recesses as the at least one lower test contactor (8) has guide pins.

6. Test device according to any one of claims 1 to 5, wherein each of the plurality of upper alignment elements (12) has at least one spring element (18).

7. Test device according to any one of claims 1 to 6, wherein the at least one upper test contactor (4) is pre-aligned or pre-alignable in the open state of the test device using four upper alignment elements (12) in a plane parallel to the upper pressing element (14).

8. Test device according to any one of claims 1 to 7, wherein the plurality of upper alignment elements (12) is fixedly connected to the upper pressing element (14).

9. Test device according to any one of claims 1 to 8, wherein the test device has a plurality of lower alignment elements (20), wherein each of the plurality of lower alignment elements (20) has at least one spring element (18),
wherein the at least one lower test contactor (8) can be pre-aligned or can be pre-alignable using four lower alignment elements (20) in a plane parallel to a lower pressing element (16),
wherein the plurality of lower alignment elements (20) can be fixedly connected to the lower pressing element (16).

10. Use of the test device for testing electronic modules on a printed circuit board (2) according to any one of claims 1 to 9, wherein the use comprises the steps:
aligning the printed circuit board (2) in the open state of the test device by means of the at least one guide pin (10) relative to the at least one lower test contactor (8),
contacting the region of the lower side of the printed circuit board (2) by means of the at least one lower test contactor (8), and
transferring the test device from the open state to the operating state, wherein the transferring comprises:
lowering the upper pressing element (14),
engaging the at least one guide pin (10) in the at least one guide recess (6), and
contacting the region of the upper side of the printed circuit board (2) by means of the at least one upper test contactor (4).

## Revendications

1. Dispositif de test, en particulier pour tester des modules électroniques sur une carte de circuits imprimés (2), comprenant :
- au moins un contacteur de test supérieur (4) destiné à établir un contact électrique avec une zone d'une face supérieure de la carte de circuits imprimés (2), dans lequel l'au moins un contacteur de test supérieur (4) présente au moins un évidement de guidage (6),
- au moins un contacteur de test inférieur (8) destiné à établir un contact électrique avec une zone d'une face inférieure de la carte de circuits imprimés (2), dans lequel l'au moins un contacteur de test inférieur (8) présente au moins une tige de guidage (10) pour orienter la carte de circuits imprimés (2) par rapport à l'au moins un contacteur de test inférieur (8),
dans lequel l'au moins une tige de guidage (10) dépasse de l'au moins un contacteur de test inférieur (8),
dans lequel l'au moins une tige de guidage (10) vient en prise, dans un état de fonctionnement du dispositif de test, avec l'au moins un évidement de guidage (6), ce qui permet d'orienter l'au moins un contacteur de test supérieur (4) par rapport à la carte de circuits imprimés (2) et à l'au moins un contacteur de test inférieur (8),
- un élément de pression supérieur (14) destiné à presser l'au moins un contacteur de test supérieur (4) contre la zone, avec laquelle un contact doit être établi, de la face supérieure de la carte de circuits imprimés (2),
**caractérisé en ce que** le dispositif de test présente de plus une pluralité d'éléments d'orientation supérieurs (12) destinés à orienter l'au moins un contacteur de test supérieur (4) dans un état ouvert du dispositif de test par rapport à l'élément de pression supérieur (14), dans lequel le dispositif de test comprend une pluralité desdits contacteurs de test supérieurs (4) et une pluralité desdits contacteurs de test inférieurs (8).

2. Dispositif de test selon la revendication 1, dans lequel l'au moins une tige de guidage (10) se rétrécit radialement dans la direction, dans laquelle l'au moins une tige de guidage (10) dépasse de l'au moins un contacteur de test inférieur (8) et/ou
dans lequel l'au moins un évidement de guidage (6) présente des flancs obliques.

3. Dispositif de test selon l'une quelconque des revendications 1 à 2, dans lequel l'au moins une tige de guidage (10) est réalisée en forme de languette, et/ou
dans lequel l'extrémité, dépassant de l'au moins un contacteur de test inférieur (8), de l'au moins une tige de guidage (10) est arrondie, et/ou
dans lequel l'au moins une tige de guidage (10) et l'au moins un contacteur de test inférieur (8) sont réalisés en une partie ou en plusieurs parties.

4. Dispositif de test selon l'une quelconque des revendications 1 à 3, ans lequel l'au moins un contacteur de test inférieur (8) présente au moins deux tiges de guidage.

5. Dispositif de test selon l'une quelconque des revendications 1 à 4, dans lequel l'au moins un contacteur de test supérieur (4) présente autant d'évidements de guidage que l'au moins un contacteur de test inférieur (8) présente de tiges de guidage.

6. Dispositif de test selon l'une quelconque des revendications 1 à 5, dans lequel chacun de la pluralité d'éléments d'orientation supérieurs (12) présente au moins un élément de ressort (18).

7. Dispositif de test selon l'une quelconque des revendications 1 à 6, dans lequel l'au moins un contacteur de test supérieur (4) est orienté au préalable ou peut être orienté au préalable dans un plan de manière parallèle par rapport à l'élément de pression supérieur (14) à l'aide de quatre éléments d'orientation supérieurs (12) dans l'état ouvert du dispositif de test.

8. Dispositif de test selon l'une quelconque des revendications 1 à 7, dans lequel la pluralité d'éléments d'orientation supérieurs (12) est reliée de manière stationnaire à l'élément de pression supérieur (14).

9. Dispositif de test selon l'une quelconque des revendications 1 à 8, dans lequel le dispositif de test présente une pluralité d'éléments d'orientation inférieurs (20), dans lequel chacun de la pluralité d'éléments d'orientation inférieurs (20) présente au moins un élément de ressort (18),
dans lequel l'au moins un contacteur de test inférieur (8) peut être orienté au préalable ou peut être orientable au préalable dans un plan de manière parallèle par rapport à un élément de pression inférieur (16) à l'aide de quatre éléments d'orientation inférieurs (20),
dans lequel la pluralité d'éléments d'orientation inférieurs (20) peut être reliée de manière stationnaire à l'élément de pression inférieur (16).

10. Utilisation du dispositif de test pour tester des modules électroniques sur une carte de circuits imprimés (2) selon l'une quelconque des revendications 1 à 9, dans laquelle l'utilisation comprend les étapes :
d'orientation de la carte de circuits imprimés (2) dans l'état ouvert du dispositif de test au moyen de l'au moins une tige de guidage (10) par rapport à l'au moins un contacteur de test inférieur (8),
d'établissement d'un contact avec la zone de la face inférieure de la carte de circuits imprimés (2) au moyen de l'au moins un contacteur de test inférieur (8), et
le transfert du dispositif de test de l'état ouvert dans l'état de fonctionnement, dans laquelle le transfert comprend :
l'abaissement de l'élément de pression supérieur (14),
la prise de l'au moins une tige de guidage (10) avec l'au moins un évidement de guidage (6), et
l'établissement du contact avec la zone de la face supérieure de la carte de circuits imprimés (2) au moyen de l'au moins un contacteur de test supérieur (4).
